Europäisches Patentamt

European Patent Office

Office européen des brevets

(19)

(11) Publication number: **0 343 771**
**A1**

## (12) EUROPEAN PATENT APPLICATION

(21) Application number: **89302388.7**

(22) Date of filing: **10.03.89**

(51) Int. Cl.⁴: **H01P 3/02 , H01P 3/08 , H01P 3/16 , H01P 11/00**

The title of the invention has been amended (Guidelines for Examination in the EPO, A-III, 7.3).

(30) Priority: **31.03.88 JP 76346/88**

(43) Date of publication of application:
**29.11.89 Bulletin 89/48**

(84) Designated Contracting States:
**AT BE CH DE ES FR GB GR IT LI LU NL SE**

(71) Applicant: **JUNKOSHA CO. LTD.**
**25-25, Miyasaka 2-chome**
**Setagaya-ku Tokyo 156(JP)**

(72) Inventor: **Suzuki, Hirosuke**
**21-8 Koteshashi-machi 4-chome**
**Tokorozawa-shi(JP)**

(74) Representative: **Foster, David Martyn et al**
**MATHISEN MACARA & CO. The Coach House 6-8 Swakeleys Road Ickenham Uxbridge UB10 8BZ(GB)**

(54) **Transmission line.**

(57) An electrical transmission circuit for the transmission of electromagnetic waves is provided. The transmission circuit comprises a dielectric (1) having compressed regions (1A) in the form of the desired circuit, wherein electromagnetic waves are transmitted through the compressed regions (1A). Electrical conductors may be installed parallel to each other and separate from each other along or within the grooves (2). Such conductors may also be used in an alternative arrangement in which the grooves (2) are not formed by compression. In a further embodiment, grooves are formed in the surface of a dielectric in a desired pattern (such as by compression) and a transmission element whose dielectric constant is higher than that of the dielectric is installed inside each of the grooves and is used to transmit electromagnetic waves.

_Fig.1._

Xerox Copy Centre

## ELECTRICAL TRANSMISSION CIRCUIT

The invention relates to an electrical transmission circuit such as suitable for the transmission of electromagnetic waves of extremely short wavelengths, such as microwaves, submilliwaves or milliwaves.

Conventionally, transmission means for the transmission of electromagnetic waves of the abovementioned types have included coaxial lines, waveguides, microstrip lines, slot lines and dielectric lines. Among these, dielectric lines use a dielectric material as a transmission medium for wave energy. Such lines proposed in the past have included a structure combining two dielectrics with different dielectric constants as core and cladding.

Coaxial lines and waveguides are both difficult to miniaturize and difficult to integrate. Accordingly, it has been nearly impossible to develop planar circuits, such as those used in printed circuit boards, using such lines. This has also been true of dielectric lines of conventional structures. Although planar circuit development is possible in the case of microstrip lines and slot lines, there is still room for improvement in the manufacture of high-performance circuits using such lines, because of the problems related to transmission loss and transmission rate.

The invention is concerned with the problem of providing an electrical transmission circuit which allows the development of planar circuitry such as printed circuit boards, and which also achieves a decrease in transmission loss and an increase in transmission speed, thus allowing the manufacture of high-performance circuitry using such transmission circuits.

According to the invention, there is provided an electrical transmission circuit for the transmission of electromagnetic waves at short wavelengths, comprising dielectric material formed with at least one groove therein and constraining means extending longitudinally along the groove for constraining the electromagnetic waves for transmission longitudinally with respect to the groove.

According to the invention there is also provided a method of manufacturing an electrical transmission circuit for the transmission of electromagnetic waves at short wavelengths, comprising the step of forming a longitudinal groove in a block of dielectric material by compressing the dielectric material along the length of the groove so as to increase its dielectric constant and constrain the electromagnetic waves for travelling along the length of the groove.

According to the invention there is further provided an electrical transmission circuit for the transmission of electromagnetic waves, comprising a dielectric having compressed regions formed therein in a desired circuit pattern, wherein electromagnetic waves may be transmitted through said compressed regions.

According to the invention there is still further provided an electrical transmission circuit for the transmission of electromagnetic waves, comprising a dielectric having grooves therein in a desired pattern and having at least two electrical conductors installed parallel to each other and separate from each other along each of said grooves, wherein electromagnetic waves may be transmitted through said conductors.

According to the invention there is yet further provided an electrical transmission circuit for the transmission of electromagnetic waves, comprising a dielectric having grooves therein in a desired pattern and having a transmission element made of further dielectric material whose dielectric constant is higher than that of said first-mentioned dielectric and installed in each of said grooves, wherein electromagnetic waves may be transmitted through said elements.

Electrical transmission circuits embodying the invention will now be described, by way of example only, with reference to the accompanying drawings, in which:

Fig. 1 is an oblique partly sectioned view of one of the circuits;

Figs. 2 and 3 are cross-sectional views which illustrate other examples of compressed portions 1A of Fig. 1;

Fig. 4 is an oblique cross-sectional view of another of the circuits;

Fig. 5 is a cross-section through a third one of the circuits;

Figs. 6-8 are cross-sections through further ones of the circuits;

Fig. 9(a) is an oblique cross-sectional view of a further one of the circuits and Figs. 9(b) and 9(c), respectively, are views of the left end and right end of the circuit of Fig. 9(a);

Fig. 9(d) illustrates another variation in the cross-sectional shape of a compressed portion 1A of the circuit of Fig. 9(a);

Fig. 10 is an oblique cross-sectional view of an eighth one of the circuits;

Figs 11a and 11b are diagrams which illustrate the method of manufacture of a ninth one of the circuits, Fig. 11(a) illustrating the state of the dielectric prior to compression;

Figs 12 to 26 are oblique cross-sectional views of further ones of the circuit; and

Figs. 27 to 35 are oblique views illustrating still further ones of the circuits.

The drawings illustrate electrical transmission circuits for the transmission of electromagnetic waves. In a first embodiment, the transmission circuits use a dielectric having compressed regions in the form of the desired circuit, wherein electromagnetic waves are transmitted through the compressed regions. In a second embodiment, grooves are formed in the surface of a dielectric in a desired pattern and at least one electrical conductor is installed parallel along the grooves. In a third embodiment, grooves are formed in the surface of a dielectric in a desired pattern and a transmission element whose dielectric constant is higher than that of the dielectric is installed inside each of the grooves and is used to transmit electromagnetic waves.

The transmission circuits of the first embodiment are designed so that, as a result of one portion of a dielectric being compressed, the dielectric constant of the compressed portion is increased compared to that of the non-compressed portion of the dielectric, and the portion with the increased dielectric constant is used as a transmitting element for the transmission of electromagnetic waves.

The transmission circuits of the second embodiment are designed so that grooves are formed in the surface of a dielectric, and at least two electrical conductors are installed parallel to each other and separated from each other along each of these grooves, either inside the grooves or adjacent the grooves.

The transmission circuits of the third embodiment are designed so that grooves are formed in the surface of a dielectric, and an element whose dielectric constant is higher than that of the dielectric is installed inside each of the grooves and is used as a transmitting element for the transmission of electromagnetic waves.

In the first of these embodiments, there is a difference in dielectric constant between compressed portions and non-compressed portions of the dielectric. Accordingly, when electromagnetic waves are sent to a portion whose dielectric constant has been increased by compression, these electromagnetic waves are confined to the compressed portion, and are transmitted with little attenuation.

In the second of these embodiments, the dielectric constant of the grooves in the dielectric is that of air. Accordingly, electromagnetic waves are concentrated between the facing electrical conductors, so that the waves are transmitted with little radiation to other areas, and with little attenuation. Similarly, in the third of these embodiments, the elements having a high dielectric constant act as electromagnetic wave transmission lines.

Various examples will now be described below with reference to the drawings.

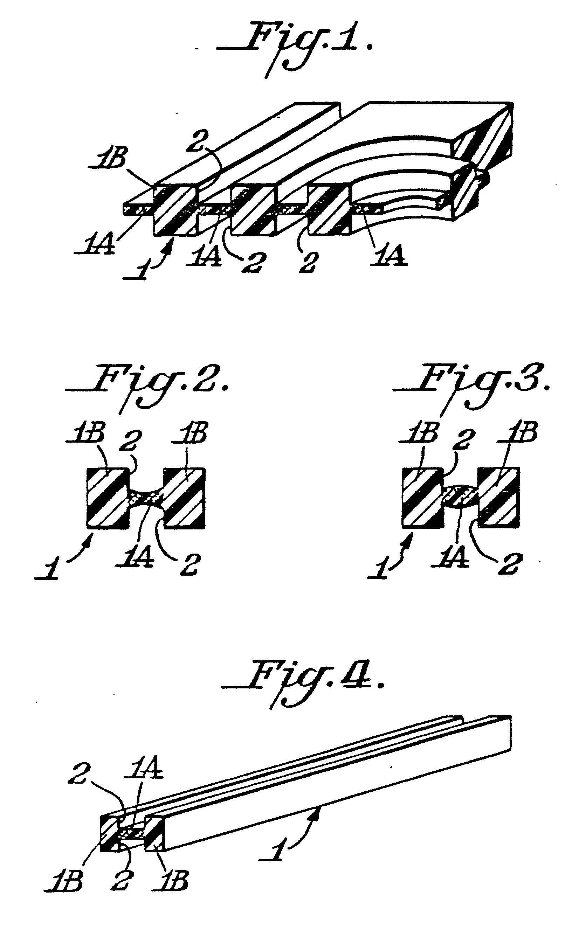

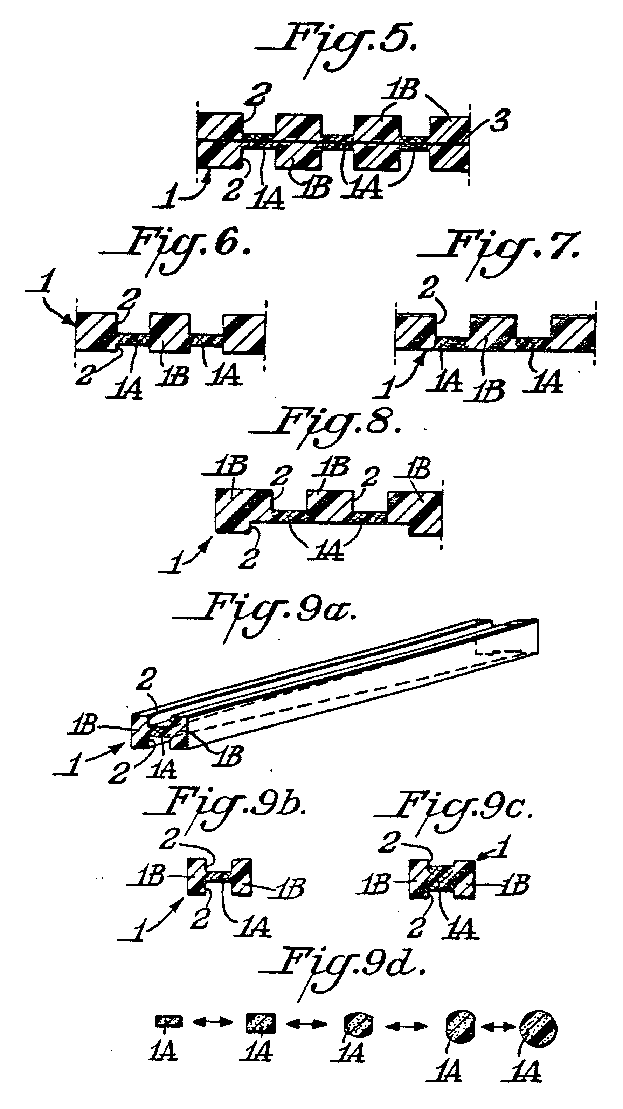

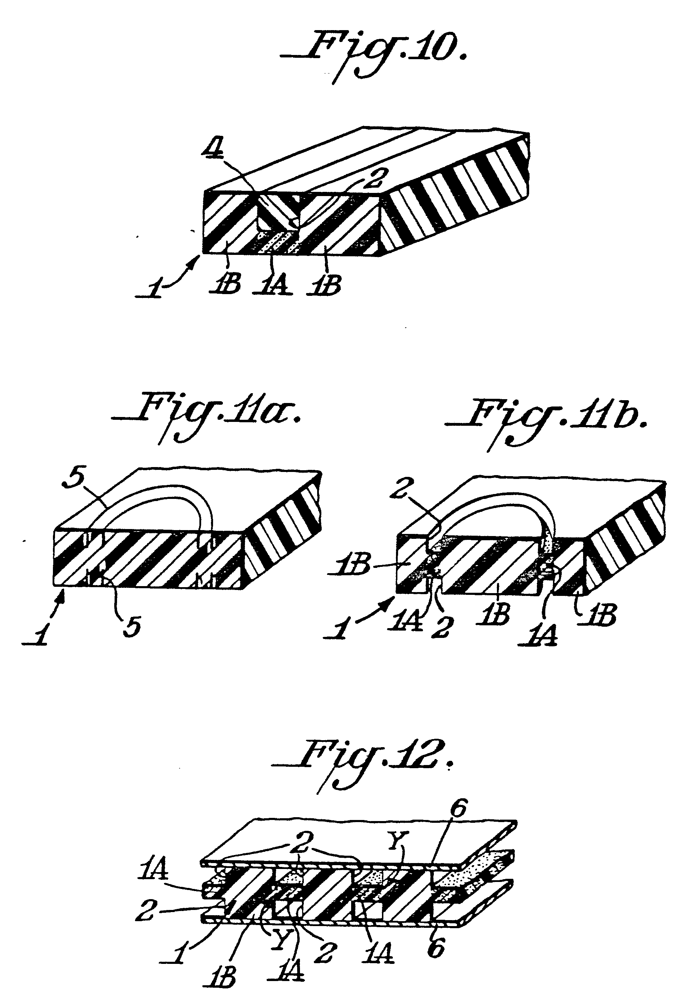

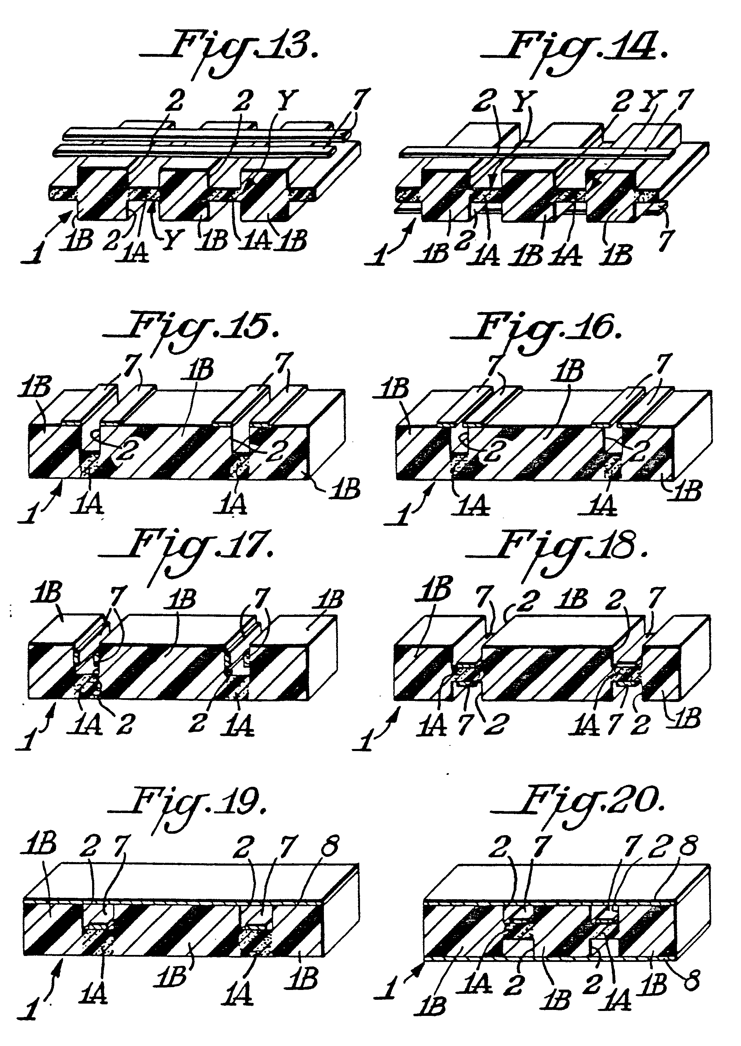

In the transmission circuit of Fig. 1, the top and bottom surfaces of a plate-like dielectric are compressed in the direction of thickness along paths where it is desired to form a transmission circuit. As a result of this compression, grooves 2 are formed. Accordingly, the dielectric constant of the compressed portions 1A is increased compared to the dielectric constant of the non-compressed portions 1B, and these compressed portions 1A with an increased dielectric constant act as transmission lines for the transmission of electromagnetic waves.

In this example, the compression is performed uniformly on the top and bottom sides of the dielectric 1, so that the compressed portions 1A are positioned roughly in the centre of the direction of thickness of the dielectric 1, and so that the cross-sectional shape of the compressed portions 1A is rectangular. The grooves 2 are formed symmetrically on the top and bottom surfaces. A plurality of transmission lines with this structure are developed in a planar arrangement. It would also be possible to form the compressed portions 1A so that they had the shape of a concave lens in cross-section, as shown in Fig. 2, or so that they had the shape of a convex lens in cross-section, as shown in Fig. 3.

In the example shown in Fig. 1, several transmission lines are formed along the plane of a plate-like dielectric 1. However, it would also be possible to form a transmission line in a band-like or rod-like dielectric 1 as shown in a second example of application illustrated in Fig. 4.

In a third example of application illustrated in Fig. 5, a dimensionally-stable layer 3 is installed in the central portion of each compressed portion 1A. During compression, deformation occurs in the lateral direction of each compressed portion 1A, i.e., in the planar direction, but this deformation is checked by the dimensionally-stable layer 3. For the dimensionally-stable layer 3, it is desirable to use a material such as a glass cloth or resin film, which shows little deformation in the planar direction. This material is incorporated at the time that the dielectric 1 is moulded.

In the example shown in Fig. 1, the compressed portions 1A are positioned in the centre of the thickness of the dielectric 1. However, it would also be possible to offset the compressed portions 1A toward either the top or bottom surface of the dielectric 1. A fourth example illustrated in Fig. 6 shows a case where the compressed portions 1A are offset toward the bottom surface of the dielectric 1. A fifth example illustrated in Fig. 7 shows a case where the compressed portions 1A are completely offset toward the bottom surface of the dielectric 1, so that there are no grooves in the bottom surface. A sixth example illustrated in Fig. 8 shows a case where a single bottom-side groove 2 is common to two transmission lines.

In the above examples, no mention was made of the degree of compression of the compressed portions 1A. However, it would be possible to vary the degree of compression along the length of the transmission line, i.e., in the direction of transmission, as shown in a seventh example of application illustrated in Fig. 9(a). In the example shown in Fig. 9(a), the degree of compression increases toward the left end in the Figures. Accordingly, the cross-sectional shape of the left end of the compressed portion 1A is thin, as shown in Fig. 9(b), while the cross-sectional shape of the right end is thick, as shown in Fig. 9(c). The density varies with the cross-sectional thicknesses. Accordingly, the dielectric constant also varies. In the case of the transmission circuit shown in Fig. 9(a), the degree of compression increases toward the left end. Accordingly, electromagnetic waves exit smoothly from this end. The degree of compression decreases toward the right end. Accordingly, if this circuit is connected to a waveguide, electromagnetic waves will smoothly enter the waveguide. It would also be possible to vary gradually the cross-sectional shape of the aforementioned compressed portion 1A from a rectangular shape to a circular shape, as shown in Fig. 9(d).

An eighth example illustrated in Fig. 10 shows a case where a groove 2 formed by partially compressing, cutting away or melting the dielectric 1 is refilled with a separately prepared dielectric 4 which has a higher dielectric constant than the aforementioned dielectric 1, so that the surface of the dielectric 1 is flat. This example is thus an example of the third embodiment. In this case, the overall dielectric constant around the compressed portion 1A can be adjusted by appropriately selecting the dielectric constant of the dielectric 4 with which the groove 2 is refilled.

In the case of the example shown in Fig. 10, the surface is shown as being made flat by the refilling of the groove 2 with the aforementioned separately prepared dielectric 4. However, it would also be possible to leave a previously deformed amount of the dielectric 1 protruding during moulding of the dielectric 1, and then to perform the compression process so that the compressed surface is flat.

In regard to the material used for the abovementioned dielectric 1, it is desirable to use a porous material such as a porous fluororesin, which can be deformed by compression. In particular, expanded porous polytetrafluoroethylene, disclosed in U.S. Patent 3,953,566, which is easily compressed since its pores are continuously connected so that air easily escapes to the outside when the resin is subjected to compression, is ideal for this purpose. In this case, the dielectric constant and hardness of the dielectric 1 may be adjusted by causing the dielectric 1 to contain a material such as titanium dioxide ($TiO_2$), barium titanate ($BaTiO_3$) or a heat-setting resin, by mixing or impregnation. A resin such as an epoxy resin, BT (modified polyimide) resin, polyimide resin or polyester resin, or a material containing a dielectric ceramic by mixing or impregnation, may be used for the dielectric 1.

Several methods which can be used to form the abovementioned transmission circuits will be described.

In regard to the method of compression, the following are examples of methods which can be used: (a) a method in which the surface of the dielectric is deformed using a roll which has a projecting ridge(s) on its circumference; (2) a method in which the surface of the dielectric is deformed by pressing using dies with indentations and projections which represent the circuit pattern; (3) a method in which the entire dielectric is first compressed, after which the areas where it is desired to form transmission lines are fixed in place, while the remaining areas are caused to swell by means of a vacuum process, so that compressed portions and non-compressed portions are created, and a variation in dielectric constant is thus obtained: (4) a method in which a transmission line pattern with an appropriate thickness is formed by etching the surface of the dielectric, after which the projecting unetched portions in the desired circuit pattern only are compressed, and the unetched portions are removed by chemical etching, so that a transmission circuit is obtained.

In method (4), it would also be possible to construct the circuit pattern using electrical conductors, or using another dielectric. Instead of removing the pattern, it would also be possible to leave the pattern, and to use the pattern itself as the transmission lines.

In the case of compression, it would also be possible to form cuts 5 in boundary areas beforehand, as shown in Fig. 11(a), in order clearly to delineate the boundaries between compressed portions and non-compressed portions, and then to perform the compressive deformation process using these cuts as boundaries. In a ninth example of the transmission circuit of the present invention, illustrated in Fig. 11(b), the boundaries between the compressed portions 1A and non-compressed portions 1B are clear, and the degree of concentration of the electromagnetic waves is increased. In this case, the cuts 5 may be formed throughout the entire pattern, or may be formed only in certain portions of the pattern.

Next, examples of transmission circuits which combine dielectric lines constructed by compressing the aforementioned dielectric 1 as described above, and transmission lines using electrical conductors, will be described.

Fig. 12 shows a tenth example. In this example, electrical conductor plates 6,6 are installed on the top and bottom surfaces of a dielectric 1 in which dielectric lines Y have been formed. In a transmission circuit with this type of structure, leakage of the electromagnetic waves is decreased by the action of the electrical conductor plates 6,6. Electromagnetic waves may also be transmitted with the electromagnetic wave mode adjusted so that NDR lines are obtained. It would also be possible to install electrical conductor plates 6 on only one surface of the dielectric 1, either the top or bottom surface.

Fig. 13 shows an eleventh example. In this example, a pair of band-form electrical conductors 7,7, which are arranged parallel to each other and separated from each other, are installed on the surface of a dielectric 1 in which dielectric lines Y have been formed. An electromagnetic wave transmission line of a separate system is formed by these electrical conductors 7,7.

In this case, the electrical conductors 7,7 are installed across the top surfaces of the non-compressed portions 1B so that they cross over the grooves 2 forming the dielectric lines Y.

In this example, electrical conductors 7,7 are installed only on the top surface of the dielectric 1. However, it would also be possible to install electrical conductors in a similar manner on the bottom surface of the dielectric as well as the top surface, or on the bottom surface alone.

Fig. 14 shows a twelfth example. In this example, electrical conductors 7,7 are installed separately on the top and bottom surfaces of the dielectric 1, thus forming a pair of conductors which transmit electromagnetic waves.

Fig. 15 shows a thirteenth example. In this example, electrical conductors 7,7 are installed on the top surface of the dielectric 1 along both rims of grooves 2 formed by compressive deformation of the dielectric 1. In this case, the electrical conductors 7,7 of each pair are installed parallel to each other, so that their side surfaces face each other across the gap formed by each groove 2. Accordingly, electromagnetic waves can be transmitted through the space between the electrical conductors 7,7 in each pair. Since the space of the groove 2 is preserved between each pair of electrical conductors 7,7, the electromagnetic waves that are transmitted tend not to attenuate, and the transmission rate is increased.

Fig. 16 shows a modification of the example illustrated in Fig. 15. In this example, the facing edges of each pair of electrical conductors 7,7 project out over the edges of the corresponding groove 2, so that the distance between the two electrical conductors 7,7 is narrowed. In the case of the examples illustrated in Figs. 13 to 16, it would be possible to flatten the surface of the dielectric by filling the grooves with another dielectric, or to install a separate flat dielectric sheet on the surface of a dielectric with indentations and projections, and then to form transmission lines on this by chemically etching a conductive sheet.

Fig. 17 shows a fourteenth example. In this example, electrical conductors 7,7 are installed facing each other on both side wall surfaces of each groove 2. Accordingly, a transmission line is formed by each pair of parallel electrical conductors 7,7 facing each other across the interior space of the corresponding groove 2.

Fig. 18 shows a fifteenth example. In this example, electrical conductors 7 are installed on the bottom surfaces of grooves 2,2 formed in the top and bottom surfaces of the dielectric 1. Accordingly, a transmission line is formed by each pair of electrical conductors facing each other through the thickness of the dielectric 1. In this case, the electrical conductors 7,7 of each pair are separated from each other by a compressed portion 1A of the dielectric.

Fig. 19 shows a sixteenth example. In this example, grooves 2 are formed by compression only in the top surface of the dielectric 1. An electrical conductor 7 is installed as a signal line on the bottom surface of each groove 2, and the top surface of the dielectric 1 is covered by a ground conductor. The electrical conductor 7 in each groove faces the ground conductor 8, so that electromagnetic waves are transmitted by these two conductors. Instead of using a ground conductor, it would also be possible to decrease the distance between adjacent grooves 2,2 so that electromagnetic waves are transmitted by the electrical conductors 7,7 inside the adjacent grooves 2,2.

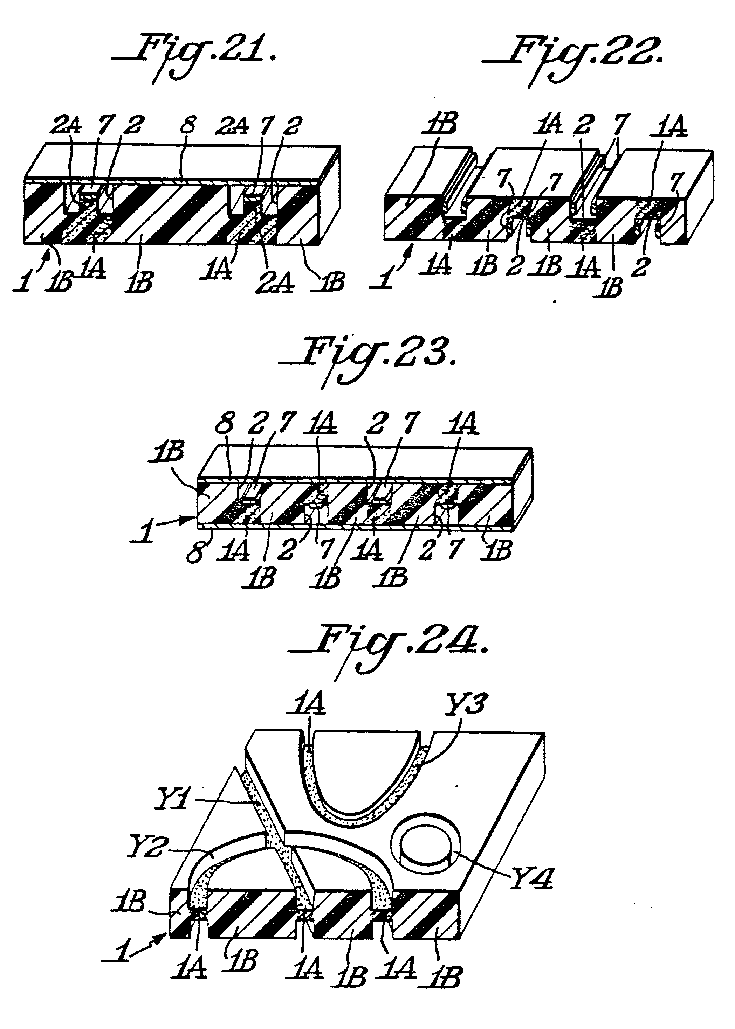

Fig. 20 shows a seventeenth example. In this example, grooves 2 are formed by compression in the top surface and bottom surface of the dielectric 1. Both the top and bottom surfaces of the dielectric 1 are covered by ground conductors 8,8, and an electrical conductor 7 is installed as a signal line on the bottom surface of each groove 2 formed in the top surface of the dielectric.

Fig. 21 shows an eighteenth example. In this example, grooves 2 are formed by compression in the top surface of the dielectric 1, and a small projection 2A which runs along the length of each groove 2 is formed on the bottom surface of each groove 2. Accordingly, a space is formed around each of these projections 2A. An electrical conductor 7 is installed as a signal line on the top surface of each projection 2A. Electromagnetic waves are transmitted by these electrical conductors 7 and by a ground conductor 8 which covers the top surface of the dielectric 1. If the space around the supporting part of each electrical conductor 7 inside each groove 2 is increased as in this example, the electromagnetic waves are correspondingly concentrated in the space between each electrical conductor 7 and the ground conductor 8, so that the transmission rate is increased and transmission loss is decreased.

Fig. 22 shows a nineteenth example. In this example, grooves 2 are formed in both the top and bottom surfaces of the dielectric 1. The grooves 2 in the top surface are offset in the lateral direction of the dielectric 1 from the grooves 2 formed in the bottom surface, so that alternating top-surface and bottom-surface grooves 2 form a zig-zag pattern in cross-section. Furthermore, electrical conductors 7,7 are installed in facing pairs on the interior side walls of each groove 2. When top-surface and bottom-surface grooves 2 are alternately positioned as in this example, the distance between adjacent transmission lines is increased, so that crosstalk is decreased.

Fig. 23 shows a twentieth example. In this example, electrical conductors 7 are installed on the bottom surfaces of grooves 2 which are alternately formed in the top and bottom surfaces of the dielectric 1 in a zig-zag pattern in cross-section. These electrical conductors 7 form combinations with ground conductors 8,8 which cover the top and bottom surfaces of the dielectric 1, so that electromagnetic waves can be transmitted through the area between the respective conductors of each combination.

All of the examples illustrated in Figs. 15 to 23 have a structure which combines electrical conductor lines with dielectric lines formed by compressing the aforementioned dielectric 1. Accordingly, the signal transmission performance is greatly improved.

In the transmission circuits described in the abovementioned examples, the main transmission lines are formed by compressing portions of the dielectric from the surface. Accordingly, planar circuits such as those used in printed circuit boards can easily be developed.

Below, examples of circuits developed in a planar configuration will be described.

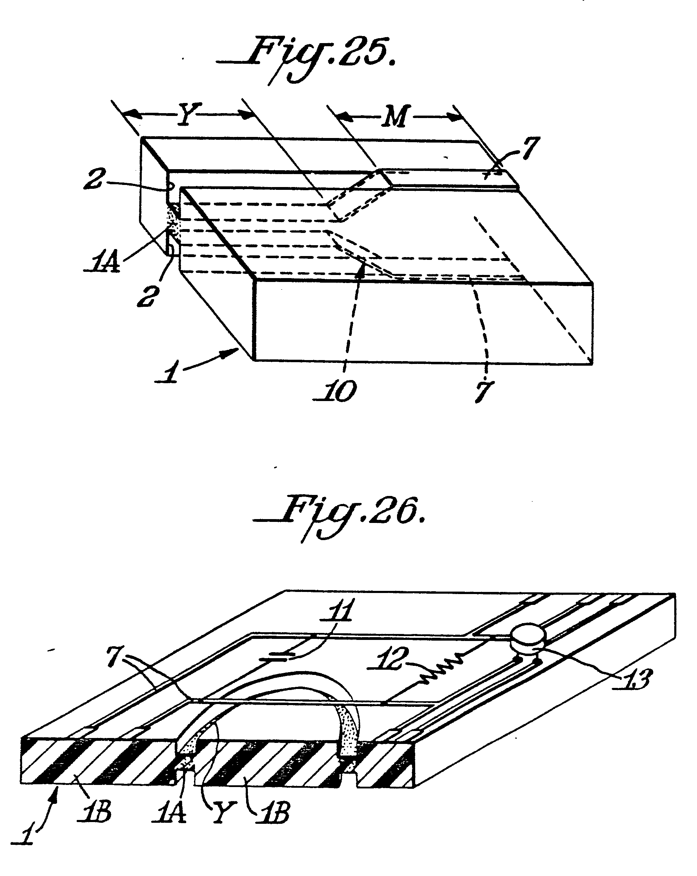

Fig. 24 shows a transmission circuit which constitutes a twenty-first example. In this example, the dielectric 1 is a flat plate-form dielectric, and several dielectric lines Y1 through Y3 which follow prescribed paths are formed in the surfaces of this dielectric 1. Dielectric lines Y1 through Y3 are of the same type, and are installed so that they are associated with each other. For example, dielectric lines Y1 and Y2 intersect, while the bent portions of dielectric lines Y2 and Y3 are positioned so that they approach each other. Y4 is a ring resonator. A signal supplied to dielectric line Y2 is amplified by the action of this ring resonator Y4, so that dielectric line Y2 is equipped with a filter function.

Fig. 25 shows a twenty-second example. In this example, a converter which connects different types of transmission lines is installed in the circuit. In this example, a mode converter 10 is installed between a dielectric line Y formed by compression of the dielectric 1, at the left side of the Figure, and an electrical conductor line M, at the right side of the Figure, in order to connect the two lines.

Specifically, the dielectric line Y is formed by compression of the dielectric 1 as described above so that grooves 2,2 are formed in the top and bottom surfaces of the dielectric 1. However, at the end where the dielectric line Y connects with the electrical conductor line M, the degree of compression is gradually decreased so that the bottom surfaces of the grooves 2 are inclined, and connect with the top and bottom surfaces of the dielectric 1. Meanwhile, a pair of electrical conductors 7,7, which constitute the electrical conductor line M, are installed on the top and bottom surfaces of the dielectric 1 so that they face each other through the thickness of the dielectric 1. The ends of these electrical conductors 7 are positioned so that they extend to the aforementioned inclined surfaces. The portions of thse electrical conductors 7,7, which are installed on the aforementioned inclined surfaces constitute a mode converter. As a result of this construction, signals can be smoothly transmitted between the dielectric line Y and the electrical conductor line M.

Fig. 26 shows a twenty-third example, in which a printed circuit board configuration is constructed. In this example, a dielectric line Y which consists principally of a compressed portion 1A is formed by compressing a portion of a flat plate-like dielectric 1. Electrical conductors 7 are installed as transmission lines of a different mode in non-compressed areas 1B of the dielectric 1, where no dielectric line Y is formed. Other electrical conductors 7 are installed so that they intersect with the dielectric line Y, and circuit elements such as capacitors 11, resistors 12 and amplifiers 13 are incorporated in the necessary places.

Such planar circuit development can be accomplished by the same method used for conventional printed circuit boards. The use of such a flat circuit construction facilitates mass production and the construction of multilayer transmission circuits.

In regard to the electrical conductors described above, a super-conducting material may also be used for the conductors. The transmission performance would be improved even further in such a case. Furthermore, the selection of electrical conductors is wide ranging, for example, at least some of the electrical conductors may consist of resistors. Furthermore, when the aforementioned electrical conductors are fastened to the surface of the dielectric, it is also permissible to interpose an adhesive layer consisting of a thermally fusible fluororesin between the conductors and the surface of the dielectric 1. Examples of other resins which may be interposed include heat-setting resins such as epoxy resins, BT resins and polyimide resins. In cases where transmission lines are laid across the aforementioned grooves 3, other modifications may be made in order to facilitate mass production, e.g., the grooves 2 may be filled with another dielectric so that a flat surface is obtained, or transmission circuits may be installed by installing a dielectric sheet on the surface of the aforementioned dielectric, covering this dielectric sheet with a metal sheet, and then chemically etching this assembly. Circuit patterns may also be formed by the socalled "additive method", in which a pattern is first formed by means of a catalyst, after which the pattern is constructed by means of a metal.

Next, examples of application of the aforementioned second embodiment will be described.

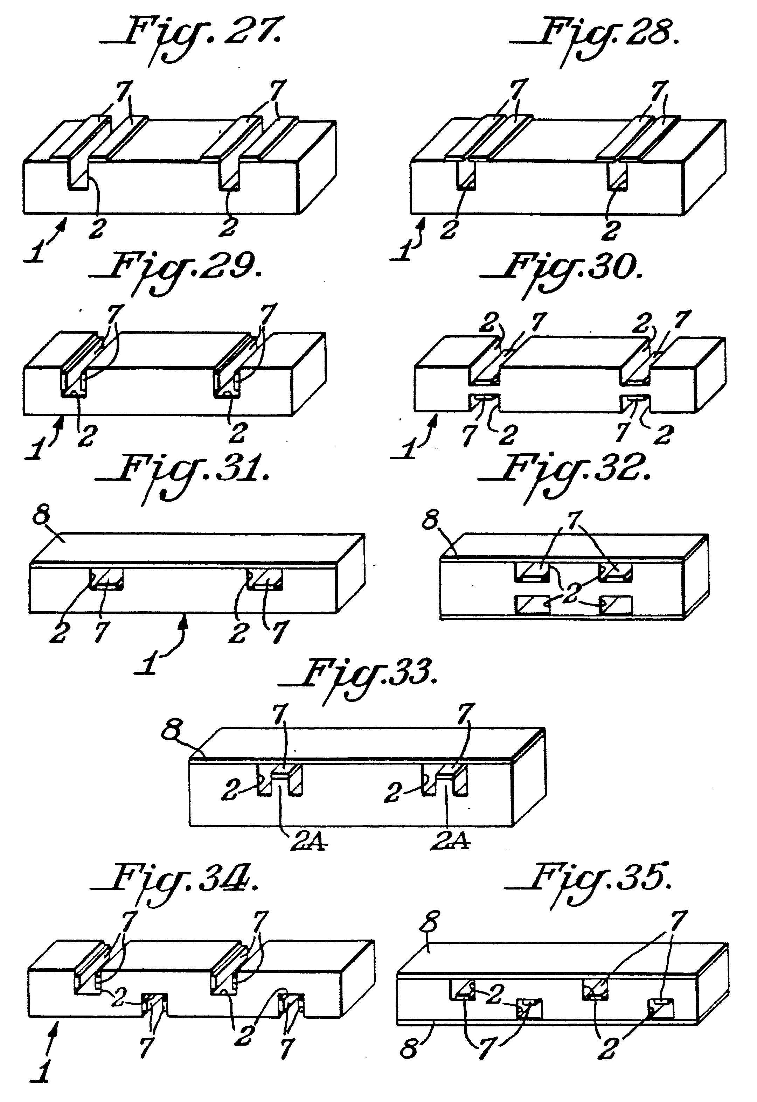

Figs. 27 to 35 illustrate various examples of the aforementioned second embodiment. These examples correspond to the examples of the first embodiment illustrated in Figs. 13 to 20. The basic difference between the two sets of examples is as follows. In the case of examples of the aforementioned first embodiment, the areas under the bottom surfaces of the grooves 2 consist of compressed portions 1A which have a higher dielectric constant than non-compressed portions. In the case of examples of the second embodiment, on the other hand, the grooves 2 are not limited to grooves formed by compression. In the case of the second embodiment, therefore, the relative magnitude of the dielectric constant of the portions of the dielectric beneath the bottom surfaces of the grooves 2 does not come into question. All other structures and functions of these examples are the same as described above. Accordingly, a detailed description is omitted here. In either case, whether the grooves 2 are compressed or not, the installation of electrical conductors along the aforementioned grooves 2 results in the formation of air transmission lines, so that transmission loss is reduced and the transmission rate is increased. As a result, such circuits have an increased usefulness for the construction of high-density circuit boards.

As described above, the transmission circuits of the first embodiment can be formed by compressing portions of a dielectric.

Accordingly, a planar circuit can be developed on the surface of the dielectric. Thus, a printed circuit board can be constructed by combining transmission lines of the same or different types. Accordingly, the examples described have increased usefulness as circuit boards for incorporation into microwave devices, milliwave devices or computers.

In the second embodiment, electrical conductors are not simply installed on the surface of a dielectric, but are rather installed along grooves formed in the dielectric. Accordingly, the electromagnetic waves that are transmitted are concentrated between the electrical conductors, and are therefore transmitted with little radiation to the outside of attenuation. As a result, the transmission rate is increased and transmission loss is decreased, so that a high-performance, high-density circuit board for incorporation into computers can be manufactured.

In the case of the third embodiment, an effect similar to that of the aforementioned first embodiment is obtained.

While the invention has been disclosed herein in connection with certain embodiments and detailed descriptions, it will be clear to one skilled in the art that modifications or variations of such details can be made without deviating from the gist of this invention, and such modifications or variations are considered to be within the scope of the claims hereinbelow.

## Claims

1. An electrical transmission circuit for the transmission of electromagnetic waves at short wavelengths, comprising dielectric material (1) and characterised by at least one groove (1A) formed therein and by constraining means (1A;4;6,7) extending longitudinally along the groove (2) for constraining the electromagnetic waves for transmission longitudinally with respect to the groove (2).

2. A circuit according to claim 1, characterised in that the groove (1A) is formed by compressing a longitudinally extending portion (1A) of the dielectric material whereby (1) the compressed dielectric material (1A) defines the groove (2) and has an increased dielectric constant, and the constraining means (1A) comprises the compressed dielectric material.

3. A circuit according to claim 2, characterised by means (3) embedded in the compressed dielectric material for substantially preventing its deformation in a direction transverse to the direction of compression.

4. A circuit according to claim 2 or 3, characterised in that the degree of compression of the dielectric (1A) material and/or its cross-sectional shape varies along the length of the or each groove (2).

5. A circuit according to any preceding claim, characterised by one or more electrical conductor means (7) associated with the or each groove (2).

6. A circuit according to claim 5, characterised in that there are two conductor means (7) for each groove, the conductor means extending along the groove adjacent and possibly overlapping its mouth.

7. A circuit according to claim 5, characterised in that at least one of the conductor means (7) is situated inside the groove (2).

8. A circuit according to any one of claims 5 to 7, in characterised in that at least one of the conductor means (6) comprises a ground plate extending across one of the surfaces of the dielectric material (1) and over the mouth of the or each groove (2).

9. A circuit according to claim 1, 2 or 3, characterised by second dielectric material (4), of higher dielectric constant than the first-mentioned dielectric material (1) and at least partially filling the groove (2), whereby the higher dielectric material (4) constrains the electromagnetic waves for transmission along the groove.

10. A method of manufacturing an electrical transmission circuit for the transmission of electromagnetic waves at short wavelengths, characterised by the step of forming a longitudinal groove (2) in a block of dielectric material (1) by compressing the dielectric material (1A) along the length of the groove (2) so as to increase its dielectric constant and constrain the electromagnetic waves for travelling along the length of the groove.

11. A method according to claim 10, characterised by the step of at least partially re-filling the groove (2) with further dielectric material (4) of higher dielectric constant than the first-mentioned dielectric material (1), whereby the further dielectric material (4) constrains the electromagnetic waves for transmission along the groove (2).

12. An electrical transmission circuit for the transmission of electromagnetic waves, characterised by a dielectric (1) having compressed regions (1A) formed therein in a desired circuit pattern, wherein electromagnetic waves may be transmitted through said compressed regions (1A).

13. An electrical transmission circuit for the transmission of electromagnetic waves, characterised by a dielectric (1) having grooves (2) therein in a desired pattern and having at least two electrical conductors (7) installed parallel to each other and separate from each other along each of said grooves (2), wherein electromagnetic waves may be transmitted through said conductors.

14. An electrical transmission circuit for the transmission of electromagnetic waves, characterised by a dielectric (1) having grooves (2) therein in a desired pattern and having a transmission element made of further dielectric material (4) whose dielectric constant is higher than that of said first-mentioned dielectric (1) and installed in each of said grooves (2), wherein electromagnetic waves may be transmitted through said elements.

Fig.1.

Fig.2.

Fig.3.

Fig.4.

*Fig.5.*

*Fig.6.* *Fig.7.*

*Fig.8.*

*Fig.9a.*

*Fig.9b.* *Fig.9c.*

*Fig.9d.*

_Fig.10._

4 2

1 1B 1A 1B

_Fig.11a._

5
1 5

_Fig.11b._

2
1B
1 1A 2 1B 1A 1B

_Fig.12._

6
1A 2 Y
2 6
1 2
1B Y 1A
1A

*Fig.13.*

*Fig.14.*

*Fig.15.*

*Fig.16.*

*Fig.17.*

*Fig.18.*

*Fig.19.*

*Fig.20.*

*Fig.21.*

*Fig.22.*

*Fig.23.*

*Fig.24.*

## Fig.25.

## Fig.26.

*Fig. 27.*

*Fig. 28.*

*Fig. 29.*

*Fig. 30.*

*Fig. 31.*

*Fig. 32.*

*Fig. 33.*

*Fig. 34.*

*Fig. 35.*

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | GB-A- 655 803 (COSSOR LTD) * Page 3, lines 39-53; figure 2 * | 13 | H 01 P 3/02 H 01 P 3/08 H 01 P 3/16 H 01 P 11/00 |
| A | | 1,5-7, 10,14 | |
| X | 5TH EUROPEAN MICROWAVE CONFERENCE, Hamburg, 1st - 4th September 1975, pages 3-12, Microwave Exhibitions and Publishers Ltd, Kent, GB; H.-G. UNGER: "Optical waveguides" * Page 5, lines 37-39; figure 10 * | 14 | |
| A | IDEM | 9,11 | |
| A | DE-A-2 504 268 (LICENTIA PATENT-VERWALTUNGS-GmbH) * Page 3, lines 9-16; figure 2 * | 1,10,12 ,13 | |
| A | GB-A-1 301 553 (THE PLESSEY CO. LTD) * Whole document * | 1,5,6, 10,12, 13 | TECHNICAL FIELDS SEARCHED (Int. Cl.4) |
| A | IEEE TRANS. ON MICROWAVE THEORY & TECHNIQUES, vol. MTT-29, no. 9, September 1981, pages 843-855, New York, US; S.-T. PENG et al.: "Guidance and leakage properties of a class of open dielectric waveguides: Part I-Mathematical formulations" * Page 844, right-hand column, lines 5-10; figure 1 * | 1,2,10, 12-14 | H 01 P |
| A | GB-A-2 185 861 (JUNKOSHA CO. LTD) * Page 2, lines 98-112; figure 5 * | 2,4,10, 12 | |

-/-

The present search report has been drawn up for all claims

| Place of search | Date of completion of the search | Examiner |
|---|---|---|
| THE HAGUE | 07-07-1989 | DEN OTTER A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)

# EUROPEAN SEARCH REPORT

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PATENT ABSTRACTS OF JAPAN, vol. 8, no. 285 (E-287([1722], 26th December 1984; & JP-A-59 152 701 (FUJITSU K.K.) 31-08-1984 * Abstract * | 2,10,12 | |
| A | PATENT ABSTRACTS OF JAPAN, vol. 10, no. 184 (E-415)[2240], 27th June 1986; & JP-A-61 30 801 (NEC CORP.) 13-02-1986 * Abstract * | 2,10,12 | |
| A | US-A-2 800 634  (GRIEG et al.) * Column 2, lines 42-51; figure 2 * | 1,5-8, 10,13, 14 | |

TECHNICAL FIELDS SEARCHED (Int. Cl.4)

The present search report has been drawn up for all claims

| Place of search | Date of completion of the search | Examiner |
|---|---|---|
| THE HAGUE | 07-07-1989 | DEN OTTER A.M. |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P0401)